# EUROPEAN PATENT SPECIFICATION

(11) **EP 1 976 352 B1**
(45) Date of publication and mention of the grant of the patent: **29.09.2010**
(21) Application number: 07707217.1
(22) Date of filing: 23.01.2007
(51) Int. Cl.: H05K 3/18, H05K 3/00, H05K 1/03

(54) **METHOD FOR ELECTROCONDUCTIVE CIRCUIT FORMATION**
VERFAHREN ZUR ELEKTROLEITFÄHIGEN SCHALTUNGSBILDUNG
PROCÉDÉ DE CONSTITUTION D'UN CIRCUIT ÉLECTROCONDUCTEUR

(30) Priority: 27.01.2006 JP 2006018434
(43) Date of publication of application: 01.10.2008
(73) Proprietor: SANKYO KASEI CO., LTD., Ohta-ku Tokyo Tokyo 146 0085 (JP)
(72) Inventor: YUMOTO, Tetsuo, Tokyo 146-0085 (JP)
(74) Representative: Schwabe - Sandmair - Marx
(86) International application number: PCT/JP2007/050954
(87) International publication number: WO 2007/086359

(56) References cited:
- EP-A- 0 273 376
- EP-A- 0 413 109
- EP-A- 1 119 227
- WO-A-03/032696
- WO-A-2006/085669
- JP-A- 7 288 374
- JP-A- 07 288 374
- JP-A- 10 308 562
- JP-A- 2001 244 610
- JP-A- 2002 374 066
- US-A- 5 084 299
- US-B1- 6 582 767

## Description

### FIELD OF THE INVENTION

The present invention relates to a method for forming an electroconductive circuit by electroless plating on the surface of a substrate which is injection-molded of a cycloolefin resin. Specifically, it relates to a method for forming an electroconductive circuit which does not require imparting polarity (also referred to as wetting) in its step of electroless plating.

### BACKGROUND OF THE INVENTION

Various methods have been proposed for forming a predetermined circuit pattern of layers of electroconductive material such as copper on the surface of a substrate of insulating resin by electroless plating in order to form electrical circuits for the use of electronic devices such as mobile phones. One of them is a method for forming a predetermined circuit pattern of layers of electroconductive material by electroless plating on the surface of a substrate that is injection-molded of a cycloolefin resin having low dissipation factor to high-frequency signal and excellent chemical resistance (for example, see Patent Document 1).

This method is as follows. Firstly, a substrate is formed by injection-molding cycloolefin resin that is a non-crystalline resin containing a flexible polymer such as a rubber elastomer, etc.. Secondly, the substrate is masked by injection molding a thermoplastic polyester resin on the surface of the substrate so that a portion on which an electroconductive circuit is to be formed is not masked. The thus-masked substrate is then soaked in an etching solution to roughen the surfaces of the substrate and the masking material. A catalyst acting as a catalyst nucleus for electroless plating is added to the roughened surface of the substrate and the masking material. Although the cycloolefin resin itself has etching resistance, as the flexible polymer such as a rubber elastomer, etc. contained in the cycloolefin resin is dissolved by the etching solution, the non-masked portion of the surface of the substrate is also roughened.

Next, the masking material covering the surface of the substrate is removed, whereby a portion of the surface of the substrate is formed, which is roughened and provided with catalyst and on which electroconductive circuit is to be formed. The substrate is wholly soaked in an electroless plating liquid, whereby an electroconductive circuit can be formed on the portion on of the surface of the substrate where an electroconductive circuit is to be formed. Meanwhile, as the portion of the substrate where the masking material has been removed is not subjected to roughening and catalyst adding that are required for electroless plating, layers of plating are not formed thereon. Therefore, insulating property of the electroconductive circuit can be secured.
Patent Document 1: JP 2003-115645A, pages 1 to 7
WO 03/032696 discloses the formation of a conductive layer of a predetermined pattern on the substrate surface by electroless plating for the production of a circuit substrate.

### DISCLOSURE OF THE INVENTION

### PROBLEM TO BE SOLVED BY THE INVENTION

The means disclosed in the above-mentioned Patent Document 1 provides a circuit substrate having low dielectric loss in high frequency region and excellent durability by using a cycloolefin resin having low dissipation factor to high-frequency signal and resistance to chemicals, heat, and water, etc. as a material for substrate for electroconductive circuit. However, this means had many problems to be improved. Firstly, in the above-mentioned means, since the mask of thermoplastic resin is also roughened by etching and provided with catalyst, an electroless plating layer is also formed on the mask. In order to selectively form an electroless plating layer only on a portion of the substrate on which an electroconductive circuit is to be formed, the mask must be removed before or after electroless plating. Therefore, a step and equipment for removing the mask is required, which leads to increases of costs and production time.

Secondly, there exist two means for forming an electroconductive circuit on an insulating substrate there exist: one is selectively electroless plating only a portion of the surface of a substrate having plating property as mentioned before; the other is conversely forming a layer to be plated of plating property on a substrate of non-plating property and carrying out electroless plating, etc. only on the layer to be plated of plating property. However, in the latter means, the layer to be plated still remains under the electroconductive circuit formed by electroless plating, etc. Therefore, for such a structure in which a layer to be plated remains on the substrate, it is desirable that the layer tobe plated also has lowdissipation factor to high-frequency signal and resistance to chemicals, heat, and water, etc., as the substrate does. Furthermore, it is also desirable to improve compatibility of the layer to be plated with the substrate to strengthen the tight adhesion between the layer and the substrate.

Fourthly, in order to impart a catalyst that acts as a nucleus for electroless plating, the surface on which the catalyst is to be imparted must have polar groups (hydrophilicity) that attract catalyst ion. Thus, a step for imparting polarity by using a surface-active agent, etc. (wetting) is necessary. If the step for imparting polarity (wetting) can be omitted, the cost and production time can be decreased. Fifthly, electroless plating is to form a plating layer of a single metal such as copper, nickel and gold, and it cannot form a plating layer of alloy. Therefore, where electroless plating is used solely, durability against contact pressure by a switch, etc., becomes insufficient, and welding, etc. of a contact for a connector on the electroconductive circuit becomes difficult.

Accordingly, It is an object of the present invention to provide a method for forming an electroconductive circuit, by which the above-mentioned problems can be solved. Specifically, the first object of the present invention is to eliminate necessity of removal of the mask formed on the substrate. The second object thereof is to provide low dissipation factor to high-frequency signal and resistance to chemicals, heat, and water, etc. for both the substrate and mask. The third object thereof is to further improve compatibility of the mask material with the substrate to strengthen the tight adhesion between them. The fourth object thereof is to omit the step of providing polarity (wetting) to impart a catalyst for electroless plating. The fifth object thereof is to form an electroconductive circuit having improved durability and welding property.

### SUMMARY OF THE INVENTION

The present inventor has done intensive studies. As a result, the inventor has found that the above-mentioned problems can be solved at once by such a way that cycloolefin resin is used as the material for both the substrate and the mask selectively covering the surface of the substrate, and besides that either the substrate or the mask is mixed with flexible polymer.

Namely, cycloolefin resin includes cycloolefin resin homopolymer and cycloolefin copolymer resin in which cycloolefin resin is copolymerized with linear olefin. As mentioned above, both of themhave low dissipation factor to high-frequency signal and resistance to chemicals, heat, and water, etc. By using those resins for both the substrate and the mask (masking layer) rather than only for the substrate, a circuit substrate having lower dielectric loss at the high-frequency region and better durability can be formed, as compared to the case where cycloolefin resin is used only for the substrate. Furthermore, by using the same resin material for both the substrate and mask, their compatibility can be improved, which allows stronger tight adhesion between them.

Further, since the cycloolefin resin itself has excellent etching resistance, it is not roughened by chemical etching and does not have polar groups (hydrophilicity) that attract catalyst ion. Therefore, the catalyst is not adsorbed on the surface. On the other hand, as for the cycloolefin resin mixed with flexible polymer, the flexible polymer is dissolved by chemical etching, whereby the surface can be readily roughened. Moreover, since the roughened surface itself has polar groups (hydrophilicity) that attract catalyst ion, a step for providing polarity (wetting) prior to addition of a catalyst is not necessary. Therefore, an electroconductive circuit can be readily formed in extremely easy steps, by electroless plating, only on the portion of the cycloolefin resin mixed with flexible polymer.

Namely, according to a first aspect of the present invention, the method for forming an electroconductive circuit comprises a first step for forming a primary substrate by injection molding cycloolefin resin mixed with flexible polymer; a second step for forming a secondary substrate by injection molding a masking layer a third step for roughening the portion not covered with the masking layer; and a fourth step for forming an electroconductive layer by electroless plating on the roughened portion, characterized in that the masking layer is formed, of cycloolefin resin not mixed with flexible polymer, which has compatibility with the primary substrate, to cover the surface of the primary substrate other than a portion thereof on which an electroconductive layer of a predetermined circuit pattern is to be formed; wherein a step for providing polarity (wetting) is omitted in the fourth step.

Alternatively, conversely to the above-mentioned means, a primary substrate is formed of cycloolefin resin not mixed with flexible polymer, and a layer to be plated is formed on the surface of the primary substrate by injection molding cycloolefin resin mixed with flexible polymer. Thereby, an electroless plating layer can be selectively formed only on the surface of the layer to be plated, and the layer can possess similar properties to those mentioned above. Therefore, according to a second aspect of the present invention, the method for forming an electroconductive circuit comprises a first step for forming a primary substrate by injection molding cycloolefin resin not mixed with flexible polymer; a second step for forming a secondary substrate by injection molding a masking layer a third step for roughening the surface of the masking layer to be plated; and a fourth step for forming an electroconductive layer by electroless plating on the roughened portion, characterized in that the masking layer is formed of cycloolefin resin mixed with flexible polymer, which has compatibility with the primary substrate, on a portion of the surface of the primary substrate on which an electroconductive layer of a predetermined circuit pattern is to be formed; wherein a step for providing polarity (wetting) is omitted in the fourth step.

It is desirable that the above-mentioned primary substrate has a through-hole, and that a portion of the layer to be plated is injectionmolded onto the both surfaces (sides) of the primary substrate via the through-hole. By this structure, for example, in covering the both surfaces (sides) of the primary substrate with layers to be plated, it is sufficient to fill the cycloolefin resin into a mold from only one surface (side) of the primary substrate, whereby the form of the mold, etc. can be simplified.

Further, it is preferable to constitute the method so as to include a fifth step for forming an electrolysis plating on the electroconductive layer after the fourth step for forming the electroconductive layer, and a sixth step for removing residues of non-electroconductive deposit which is left on the surface of the cycloolefin resin not mixed with flexible polymer by chemical dissolution. Namely, by electrolysis plating on the electroless plating layer, for example, a thick alloy plating can be rapidly laminated, whereby an electroconductive circuit having excellent durability and welding property can be formed. Furthermore, if residues of catalyst or plating are left on the surface of the cycloolefin resin which is not mixed with flexible polymer, namely, the portion of the surface on which an electroconductive layer is not to be formed, insulating deficiency, etc. may occur. Therefore, it is desirable to remove those residues by chemical dissolution, etc. However, in a case in which an electrolysis copper plating is formed on an electroconductive layer of electroless copper plating, the electrolysis plating layer forming the electroconductive layer may also be deteriorated during chemical dissolution of the residue. In such a case, if an electrolysis gold plating is formed, residues of copper and nickel, which are used for ground plating, can be dissolved and removed by nitric acid, while the gold plating cannot be dissolved by nitric acid. Therefore, unnecessary residue can be selectively removed by dissolution.

Accordingly, in the present invention, those residues are removed by chemical dissolution, and an electrolysis plating is provided on an electroless plating layer so as to have a margin thickness prepared for erosion by chemical dissolution.

It is desirable that the above-mentioned cycloolefin resin is a cycloolefin copolymer resin comprising cycloolefin resin and linear olefin. Since cycloolefin copolymer resin not mixed with flexible polymer is transparent, light can readily pass therethrough. Therefore, when cycloolefin copolymer resin not mixed with flexible polymer is used for such as primary substrate, an electroconductive circuit having multiple functions such as light illumination, light conduction, and optical functions of lenses can be formed.

Here, the "flexible polymer" refers to a material that dissolves in an etchant, and examples thereof include, for example, natural rubber, polybutadiene, polyisoprene, polyisobutylene, neoprene, polysulfide rubber, Thiokol rubber, acrylic rubber, urethane rubber, silicone rubber, epichlorohydrin rubber, styrene-butadiene block copolymer, hydrogenated styrene-butadiene block copolymer (SEB), styrene-butadiene-styrene block copolymer (SBS), hydrogenated styrene-butadiene-styrene block copolymer (SEBS), styrene-isoprene block copolymer, hydrogenated styrene-isoprene block copolymer (SEP), styrene-isoprene-styrene block copolymer (SIS), hydrogenated styrene-isoprene-styrene block copolymer (SEPS), or olefin rubbers such as ethylene propylene rubber (EPM), ethylene propylene diene rubber (EPDM), ethylene-butene copolymer, ethylene-octene copolymer, linear low density polyethylene elastomer, etc., or coreshell type particulate elastomers such as butadiene-acrylonitrile-styrene-coreshell rubber (ABS), methyl methacrylate-butadiene-styrene-coreshell rubber (MBS), methyl methacrylate-butyl acrylate-styrene-coreshell rubber (MAS), octyl acrylate-butadiene-styrene-coreshell rubber (MABS), alkyl acrylate-butadiene-acrylonitrile-styrene-coreshell rubber (AABS), butadiene-styrene-coreshell rubber, siloxane-containing coreshell rubbers such as methyl methacrylate-butyl acrylate-siloxane, etc., or rubbers obtained by modifying these rubbers, etc.

The "cycloolefin resin" include, for example, non-crystalline polymers such as addition polymer of cycloolefin monomer and ethylene, addition polymer of cycloolefin monomer, ring-opened polymer of cycloolefin monomer and hydrogenated product thereof, polymer of aromatic vinyl monomer in which the aromatic ring portion has been hydrogenated, random or block copolymer of aromatic vinyl monomer and conjugated diene monomer in which the aromatic ring portion has been hydrogenated, and polymer of alicyclic vinyl monomer. The cycloolefin monomer refers to cycloolefins obtained by addition reaction of cyclopentadiene and an olefin, etc., multi-ring unsaturated hydrocarbons such as dicyclopentadiene and tetracyclododecene, etc., as well as derivatives of multi-ring unsaturated hydrocarbons such as alkyl-substituted forms thereof, and polar group-substituted forms thereof obtained by substituting a polar group such as a carboxyl group, an acid anhydride group, an epoxy group, an amide group, and an ester group, etc.

The "primary substrate" means a component or a portion of the component, on the surface of which the "masking layer" or "layer to be plated" mentioned hereafter can be injection molded. The shape of the primary substrate is not limited. Furthermore, the primary substrate is used not only for forming plane circuits but also for forming solid or cubic circuits. The "predetermined circuit pattern" refers to a portion of the substrate on which an electroconductive circuit is to be formed by electroless plating mentioned hereafter, which shape includes not only two-dimerisional one but also three-dimensional one. Furthermore, the "predetermined circuit pattern" also includes one provided on the surface of the internal space of the primary substrate, in which an aperture of the internal space is formed on the surface of the primary substrate. The "electroconductive layer" refers to a metal layer that is formed by electroless plating mentioned hereafter.

The "masking layer" refers to a cover layer that covers the portion other than the predetermined portion on the surface of the primary substrate, which finally insulates the electroconductive circuits formed on the surface of the primary substrate each other. The "secondary substrate" refers to whole of the primary substrate and the "masking layer" or "layer to be plated" mentioned below that has been injection molded on the surface of the primary substrate. The "roughening" refers to that, where the primary substrate or layer to be plated on which the above-mentioned "flexible polymer" has been mixed has been injection molded is soaked into an etchant, surface roughness is increased by defect portions formed by selectively dissolving the "flexible polymer" that has been mixed and distributed on the surface layer of the primary substrate or layer to be plated and removing the polymer.

The "electroless plating" is a known technique, which refers to a method in which electron is discharged by oxidization decomposition of a reducing agent in a plating liquid, and the metal dissolved in the plating liquid is deposited on the surface to be plated by reduction due to the free electron. Examples of metal that forms an electroconductive layer by electroless plating include copper, nickel, cobalt, tin, etc. The "providing polarity (wetting)" refers to, as mentioned above, providing polar groups (hydrophilicity) that attract catalyst ion to the surface on which a catalyst has been imparted, by using a surfactant, etc.

The "electrolysis plating" refers to a known technique in which an electric current is applied to an electrolyte solution including metal ion to deposit the objective metal on a plate surface. In the present invention, an electroless plating layer is used as a cathode, and the objective metal is deposited on the electroless plating layer. The metal for electrolysis plating include, for example, copper, nickel, chromium, tin, gold, silver, platinum, indium, oralloysincludingthesemetals. The "non-electroconductive deposit" refers to metal deposited by a catalyst or electroless plating, and includes, for example, initial copper plating (non-continuous film).

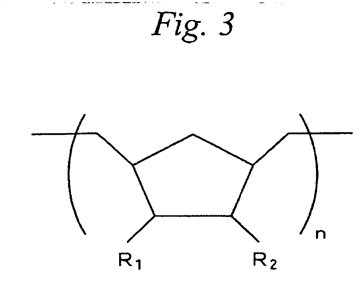

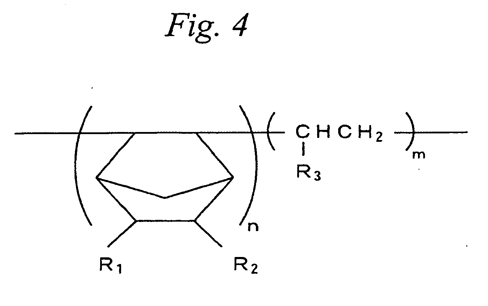

The "cycloolefin resin" refers to a polymer having an alicyclic structure synthesized using cycloolefins as a monomer in the main chain. Examples of the chemical structural formula are shown in Figs. 3 and 4. Specific examples of the resin having the chemical structural formula shown in Fig. 3 include "ZEONEX (registered trademark)" and "ZEONOR (registered trademark)", both manufactured by Zeon Corporation, and "ARTON" manufactured by JSR Corporation, etc. Examples of the copolymer of a cycloolefin monomer and a linear olefin having the chemical structural formula shown in Fig. 4 include "Topas" manufactured by Ticona, and "Apel" manufactured by Mitsui Chemicals, Inc., etc.

### EFFECT OF THE INVENTION

Firstly, by omitting the step for removing the mask formed on the substrate, the cost and time for forming a circuit can be reduced. Secondly, using a cycloolefin resin for both the substrate and mask, dissipation factor to high-frequency signal can be further decreased, and chemical resistance, heat resistance, and water resistance, etc. can be provided. Thirdly, the compatibility of the mask material with the substrate can be further improved, whereby tight adhesion property between them can be further strengthened. Fourthly, by omitting the step for providing polarity (wetting) to add a catalyst for electroless plating, the cost and production time can be reduced.

Fifthly, by laminating electrolysis plating on an electroless plating, an electroconductive circuit having improved durability and welding property can be formed. Furthermore, by laminating such electrolysis plating, excess erosion of the electroconductive layer can be prevented while removing the residue, such as a catalyst, etc. remained on the portion other than the portion on which an electroconductive layer is to be formed, using chemical dissolution. Moreover, by providing a through-pore to the primary substrate, simplification, etc. of the form of a mold can be achieved. In addition, by using a cycloolefin copolymer resin in which a flexible polymer has not been mixed, for example, for the primary substrate, multifunctional articles further having optical functions can be formed.

### BRIEF DESCRIPTION OF THE DRAWINGS

Fig. 1 is a drawing showing the procedures for forming an electroconductive circuit;
Fig. 2 is a drawing showing another procedures for forming an electroconductive circuit;
Fig. 3 is a chemical structural formula showing a specific example of a cycloolefin resin; and
Fig. 4 is a chemical structural formula showing a specific example of a copolymer of a cycloolefin monomer and a linear olefin.

### DESCRPTION OF THE REFEERNCE NUMERALS

1 and 11: primary substrate
1a: portion on which electroconductive layer is to be formed
1b: portion other than the portion on which electroconductive layer is to be formed (portion coated by masking layer)
12: layer to be plated
2: masking layer
3 and 13: secondary substrate
4 and 14: electroless plating (electroconductive layer)
5 and 15: electrolysis copper plating

### BEST MODE FOR CARRYING OUT THE INVENTION

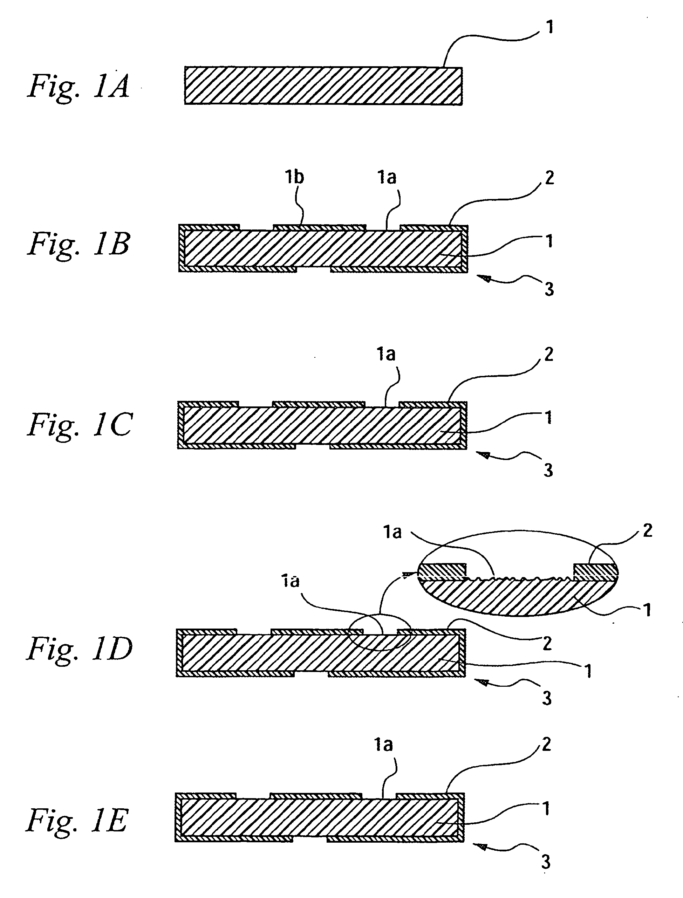

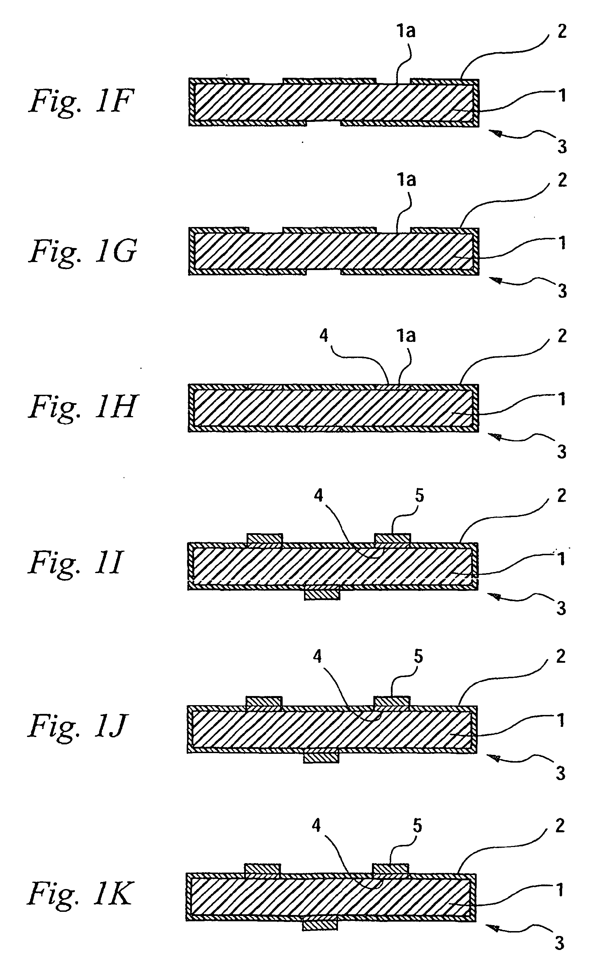

An embodiment of the method for forming an electroconductive circuit according to the present invention is explained with referring to Fig. 1. Firstly, as shown in Fig. 1 (A), cycloolefin copolymer resin, a cycloolefin resin consisting of a cycloolefin cyclic resin and a linear olefin, is mixed with styrene-ethylene-propylene-styrene block copolymer elastomer (hereinafter referred to as "SESP"), a flexible polymer (20% by weight), and the mixed and diffused material is injection molded to form a block-type primary substrate 1. The primary substrate 1 is then degreased by washing to remove dirt and oily components and dried. As shown in Fig. 1 (B) , using a cycloolefin copolymer resin having compatibility with the primary substrate 1 and consisting of cycloolefin resin not mixed with flexible polymer and linear olefin, a masking layer 2 covering a portion 1b of the surface of the primary substrate on which an electroconductive layer of a predetermined circuit pattern is not to be formed, is injection molded to form a secondary substrate 3.

Next, the secondary substrate 3 is washed, degreased (C), and dried. Then, it is soaked in an etchant so as to dissolve the SEPS constituent which is mixed and diffused in the portion 1a of the primary substrate 1 which is not covered with the masking layer 2 and on which an electroconductive layer is to be formed, as shown in Fig. 1 (D). Thereby, the surface of the portion 1a is roughened. Since the masking layer 2 itself has etching resistance, it is not roughened even soaked in the etchant and maintains hydrophobicity. As the etchant, for example, a mixed acid solution of chromic anhydride (400 g/L) and sulfuric acid (200 mL/L) is used, and soaking is carried out at the temperature of 75°C for 60 minutes.

Next, the secondary substrate 3 is neutralized in alkaline aqueous solution (E) , washed and dried. Then, it is soaked into a liquid for adding a catalyst so that palladium chloride is adsorbed on the portion 1a, which is not covered with the masking layer 2 and on which an electroconductive layer is to be formed (F). Since the portion 1a of the primary substrate 1, which is not covered with the masking layer 2 and on which an electroconductive layer is to be formed, is roughened by the etchant and provided with polarity (wet) in the above-mentioned step (D), palladium chloride is adsorbed readily and tightly. On the other hand, since the masking layer 2 itself is not roughened by the etchant and is hydrophobic, it does not adsorb palladium chloride as mentioned above. Therefore, palladium chloride is selectively adsorbed only on the portion 1a on which an electroconductive layer is to be formed. The adsorbed palladium chloride is then reduced by using an activating agent to form a catalyst nucleus consisting of metal palladium (G).

The secondary substrate 3 is then washed with water and soaked into a electroless copper plating liquid to selectively form an electroconductive layer 4 of electroless copper plating on the surface of the primary substrate 1 (H). As the electroless copper plating liquid, a general one applied toplasticmaterials may be used, for example, a solution in which 5 to 15 g/L of copper sulfate as a metal salt, 8 to 12 mL/L of formalin solution (37% by volume) as a reducing agent, 20 to 25 g/L of Rochel's salt as a complex-forming agent and 5 to 12 g/L of sodiumhydroxide as an alkaline agent have been mixed, at the temperature of 20°C, can be used. The electroconductive layer 4 of electroless copper plating is formed only on the portion 1a, namely, a portion of the surface of the primary substrate 1, which is not covered with the masking layer 2, on which an electroconductive layer is to be formed, and which is roughened and provided with catalyst nucleus. On the other hand, the electroconductive layer 4 is not formed on the masking layer 4, which is neither roughened nor provided with catalyst nucleus. Therefore, the electroconductive layer 4 is selectively formed only on the portion 1a of the surface of the primary substrate 1, on which an electroconductive layer of a predetermined circuit pattern is to be formed.

The electroless copper plating liquid is then removed by washing with water, and an electrolysis copper plating 5 is formed on the surface of the electroconductive layer 4 by using itself as a cathode (I). As the electrolysis copper plating, general one may be used. If necessary, an electrolysis nickel plating layer, electrolysisgoldplating layer and the like maybe further formed on the electrolysis copper plating 5.

When remains of catalyst or plating are left on the surface of the masking layer 2, insulating deficiency, etc. may occur. Therefore, after the forming of the electrolysis copper plating 5 (I), the secondary substrate 3 is subjected to chemical dissolution by nitric acid liquid, etc. to remove remains of catalyst or plating (J). In this step, the thickness of the electrolysis copper plating 5 formed on the electroless copper plating 4 is preferably increased to some extent. Thereby, even if electrolysis plating is conducted by using copper only, since the margin thickness is prepared against erosion by chemical dissolution, the function of the electroconductive circuit is not deteriorated. Furthermore, the erosion by chemical dissolution can be prevented also by forming gold plating on the electrolysis copper plating 5. Finally, the nitric acid liquid, etc. is neutralized by using alkaline aqueous solution, etc. (K).

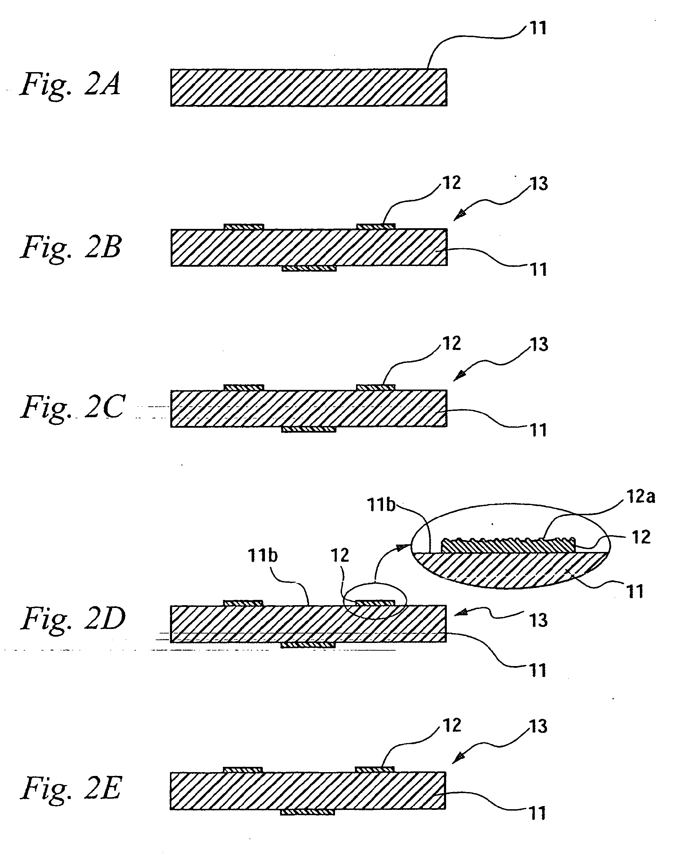

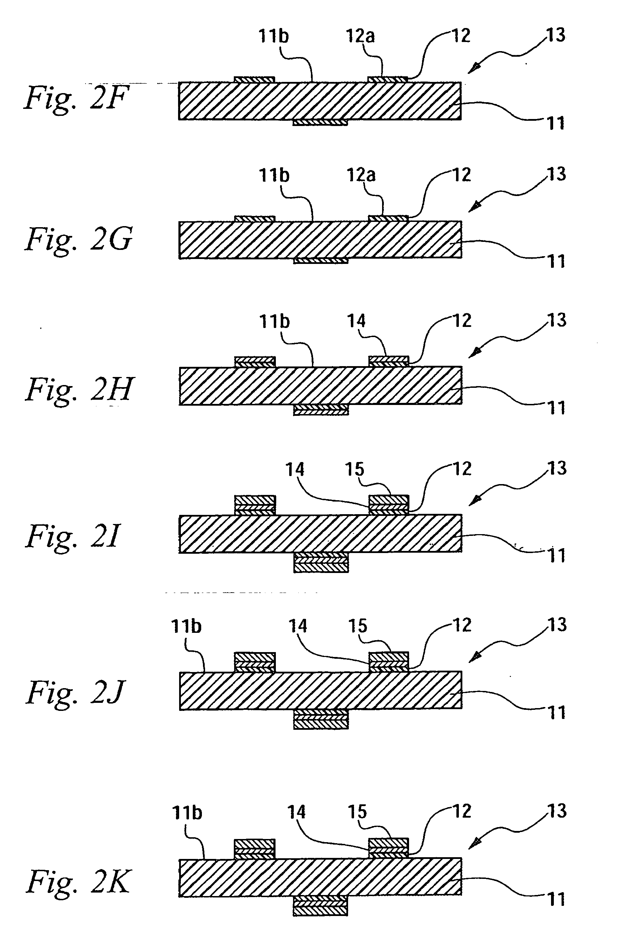

Another embodiment is explained with referring to Fig. 2. In this embodiment, the material used for the above-mentioned primary substrate 1 and that used for masking layer 2 are exchanged. For the sake of convenience, the numerals corresponding to those of the components and portions shown in Fig. 1 are represented by the numerals obtained by uniformly adding 10 to the element numbers shown in Fig. 1. As shown in Fig. 2 (A), a block-shaped primary substrate 11 is formed by injection molding cycloolefin copolymer resin, a cycloolefin resin not mixed with flexible polymer, which consists of cycloolefin resin and linear olefin.

The primary substrate 11 is then degreased by washing to remove dirt and oil and dried. Then, as shown in Fig. 2 (B), a layer to be plated 12 is formed on a portion of the surface of the primary substrate 11 on which an electroconductive layer of a predetermined circuit pattern by injection molding cycloolefin copolymer resin mixed with flexible polymer, which has compatibility with the primary substrate 11 and consists of cycloolefin resin and linear olefin, to form a secondary substrate 13. As mentioned above, 20% by weight of SESP is mixed and diffused as the flexible polymer.

The secondary substrate 13 is washed, degreased (C) and dried. Then, it is soaked into etchant. Thereby, as shown in Fig. 2 (D), since the SEPS mixed and diffused in the layer to be plated 12 is dissolved, a surface 12a of the layer to be plated 12 is roughened. Since a portion 11b of the surface of the primary substrate 11, which is not covered with the layer to be plated 12, has etching resistance, it is not roughened and maintains hydrophobicity even it is soaked in the etchant. As the etchant, those as mentioned above are used.

The secondary substrate 13 is neutralized by using alkaline aqueous solution (E), and is washed and dried. Then, it is soaked into liquid for adding catalyst, so that palladium chloride is adsorbed on the layer to be plated 12 (F). Since the surface 12a of the layer to be plated 12 is roughened by etchant and is provided with polarity (wet) in the above-mentioned step (D), palladium chloride is readily and tightly adsorbed. On the other hand, since the primary substrate 11 itself is not roughened by etchant and is hydrophobic as mentioned above, palladium chloride is not adsorbed thereon. Therefore, palladium chloride is selectively adsorbed only on the layer to be plated 12, which is a portion on which an electroconductive layer is to be formed. The adsorbed palladium chloride is then reduced using an activating agent to form a catalyst nucleus of metal palladium (G).

The secondary substrate 13 is washed with water. Then, it is soaked into electroless copper plating liquid to selectively form a electroconductive layer 14 of electroless copper plating on the surface 12a of the layer to be plated 12 (H). As the electroless copper plating liquid, those mentioned above maybe used. The electroconductive layer 14 of electroless copper plating is formed only on the surface 12a of the layer to be plated 12, which is roughened and is provided with catalyst nucleus. On the other hand, the layer 14 is not formed on the surface 11b on the primary substrate 11, which is neither roughened nor provided with catalyst nucleus. Therefore, the electroconductive layer 14 is formed only on the surface 12a of the layer to be plated 12 of a predetermined circuit pattern on the surface of the primary substrate 11.

The electroless copper plating liquid is then removed by washing with water, and the electrolysis copper plating 15 is formed on the surface of the electroconductive layer 14 by using the electroconductive layer 14 itself as a cathode (I). As the electrolysis copper plating, general one may be used. If necessary, an electrolysis nickel plating, electrolysis gold plating layer, etc. may be formed on the electrolysis copper plating 15.

After the forming of the electrolysis copper plating 15 (I), the secondary substrate 13 is subjected to chemical dissolution by nitric acid liquid, etc. to remove remains of catalyst or plating (J). In this step, the thickness of the electrolysis copper plating 15 formed on the electroless copper plating 14 is preferably increased to some extent. Thereby, even if electrolysis plating is conducted by using copper only, since the margin thickness is prepared against erosion by chemical dissolution, the function of the electroconductive circuit is not deteriorated. Furthermore, the erosion by chemical dissolution can be prevented also by forming gold plating on the electrolysis copper plating 15. Finally, the nitric acid liquid, etc. is neutralized by using alkaline aqueous solution, etc. (K).

The cycloolefin resin used for the primary substrates 1 and 11, the masking layer 2, and layer to be plated 12 may be mixed with fillers of glass fiber, bariumtitanatewhisker, etc., by which their dielectric constant can be varied, and its strength, durability, etc. can be improved. Furthermore, the cycloolefin resin may be further mixed with additives such as antiblocking agent, antioxidant, nucleus agent, antistatic, process oil, plasticizer, releasing agent, compatibilizing agent, flame retardant, flame retardant aid, pigment etc., the functional effect of each additive can be exhibited.

### WORKING EXAMPLE 1

A cycloolefin resin mixed with flexible polymer was made as follows: one hundred (100) parts of "ZEONEX # RS820" manufactured by Zeon Corporation (Tg: about 190°C, hydrogenation ratio: 99.7% or more, amount of metal element: 1 ppm or less) (100 parts) was provided with thirty (30) parts of "Septon" manufactured by Kuraray Co. Ltd., number average molecular weight: 60000, Tg: at least one point at the temperature of 40°C or less, amount of metal element : 15 ppm) as a styrene-ethylene-propylene-styrene block copolymer elastomer and with point 5 (0.5) parts of a phenol-substrated antioxidant. Thereby, a pellet of a thermoplastic composition was made. Then, by injection molding the pellet at the resin temperature of 280°C a block-shaped primary substrate was formed.

The primary substrate was then degreased by washing to remove dirt and oil and is dried. Then, a masking layer, which covers the surface of the primary substrate other than a portion thereof on which an electroconductive layer of a predetermined circuit pattern is to be formed, was injection molded by using cycloolefin resin ("ZEONEX #480", manufactured by Zeon Corporation) not mixed with flexible polymer, to form a secondary substrate. The secondary substrate is then degreased by washing, dried, and soaked in an etchant to roughen the surface of the primary substrate not covered with the above-mentioned masking layer. As the etchant, a mixed solution of chromate anhydride (400 g/L) and sulfuric acid (200 mL/L) was used, and the soaking was carried out at the temperature of 75°C for 60 minutes. As a result, only the surface of the primary substrate not covered with the masking layer was roughened and wet, and the masking layer was not roughened and wet.

The secondary substrate was then neutralized, washed and dried. As the neutralizer, "Neutralizer PM50", manufactured by Shipley Far East, Ltd., was used, and the soaking was carried out at the temperature of 50°C for 3 to 5 minutes. The secondary substrate was then soaked into a liquid for imparting a catalyst, whereby palladium chloride was adsorbed on the surface of the primary substrate not covered with a masking layer. The catalyst was imparted by soaking at the temperature of 50°C for 8 to 10 minutes, using "Catapojet 44", manufactured by Shipley Far East, Ltd. As a result, it was confirmed that palladium chloride was adsorbed on the roughened surface of the primary substrate not covered with the masking layer, without further wetting. Furthermore, it was also confirmed that palladium chloride was not adsorbed on the masking layer. The adsorbed palladium chloride was then activated to form a catalyst nucleus of palladium metal. The activation was carried out by soaking at room temperature for 10 to 12 minutes using "Accelerator 19", manufactured by Shipley Far East, Ltd.

The secondary substrate was then washed with water and soaked into electroless copper plating liquid to selectively form an electroconductive layer of electroless copper plating having a thickness of 0. 05 to 0. 3 µm on the surface of the primary substrate on which the catalyst nucleus had been formed. As the electroless copper plating liquid, a mixed liquid was used which is the mixture of 72.5 % water with 12.5 % of "Copper Mix #328L", 12.5% of "Copper Mix #238A", and 2.5 % of "Copper Mix #328C", with all of three manufactured by Shipley Far East, Ltd. , and the soaking was carried out at room temperature for 15 minutes. From the above-mentioned example, it was confirmed that an electroconductive circuit can be selectively formed by electroless copper plating only on the surface of the primary substrate, which was not covered with the masking layer and was roughened and provided with catalyst.

### WORKING EXAMPLE 2

As a cycloolefin copolymer resin consisting of cycloolefin resin and linear olefin, which is not mixed with flexible polymer, "TOPAS #RSC10001", manufactured by Polyplastics Co., Ltd. was injection molded, as mentioned above, to form a primary substrate. Dirt, dust, etc. on the surface of the primary substrate were removed by degreasing. Using "ZEONOR #1020R", manufactured by Zeon Corporation, as a cycloolefin resin not mixed with flexible polymer, which has compatibility with the primary substrate, a masking layer which covers the surface of the primary substrate other than a portion thereof on which an electroconductive layer of a predetermined circuit pattern is to be formed was formed by injection molding to form a secondary substrate.

The secondary substrate was degreased by washing and was dried. Then, it is soaked in an etchant consisting of a mixture of chromic acid and sulfuric acid, whereby the surface of the primary substrate not covered with the above-mentioned masking layer was roughened. The chromic acid adhered on the secondary substrate was neutralized and removed by using a solution of hydrochloric acid. Palladium chloride was adhered on the roughened surface of the primary substrate as mentioned above, and the palladium chloride was reduced to form a catalyst nucleus of palladium metal. Then, the secondary substrate was provided with a standard electroless copper plating for the ABS resin. As a result, it was confirmed that an electroconductive layer of electroless copper plating was formed only on the portion of the surface of the primary substrate not covered with the masking layer, which was roughened and added with catalyst, and that electroless copper plating was not formed on the masking layer.

### WORKING EXAMPLE 3

Contrary to Example 2, a primary substrate was formed by injection molding "ZEONOR #1020R", Zeon Corporation product, as a cycloolefin resin not mixed with flexible polymer. Then, a layer to be plated was injection molded on a portion of the surface of the primary substrate on which an electroconductive layer is to be formed, by using "TOPAS #RSC10001", Polyplastics Co., Ltd. product, as a cycloolefin copolymer resin consisting of cycloolefin resin and linear olefin, which is mixed with flexible polymer and has compatibility with the primary substrate, to form a secondary substrate.

The secondary substrate was then soaked into an etchant, a liquid for providing catalyst, and a liquid for electroless plating liquid according to the same procedure as mentioned above. As a result, it was confirmed that only the layer to be plated was roughened and was provided with the catalyst, that the surface of the primary substrate not covered with the layer to be plated was not roughened and was not provided with the catalyst, and that an electroless plating layer can be selectively formed only on the layer to be plated.

### WORKING EXAMPLE 4

According to a similar method to Example 3, an electroless plating layer was selectively formed on a layer to be plated that was injection-molded on the surface of the primary substrate. The electroless plating liquid was then removed by washing with water, and an electrolysis copper plating having a thickness of 5 to 10 µm was formed on the surface of the electroless plating layer by using the layer itself as a cathode. As a result, it was confirmed that an electrolysis copper plating can be rapidly formed only on the electroless plating layer by a conventional method for electrolysis copper plating.

After the forming of the electrolysis copper plating, the whole secondary substrate was subjected to chemical dissolution by using sulfuric acid liquid. As a result, it was confirmed that the electrolysis copper plating had a sufficient margin thickness prepared against erosion by chemical dissolution and that the function of the electroconductive layer was not deteriorated. Accordingly, in a case in which remains of catalyst or plating is left on a surface of the primary substrate not covered with the layer to be plated, those remains of catalyst or plating can be sufficiently removed without causing overetching to the electrolysis copper plating.

### INDUSTRIAL APPLICABILITY

In the method for forming an electroconductive circuit according to the present invention, removal of the mask formed on the substrate is not required; the substrate and mask both have low dissipation factor to high-frequency signal; compatibility between the mask material and substrate is high; and the step for providing polarity (wetting) to impart a catalyst for electroless plating is not necessary. Therefore, said method is widely available in the industries relating to electronic devices, etc.

## Claims

1. A method for forming an electroconductive circuit, comprising:
a first step for forming a primary substrate (1; 11) by injection molding a cycloolefin resin mixed with flexible polymer;
a second step for forming a secondary substrate (3; 13) by injection molding a masking layer (2);
a third step for roughening the portion of the surface of the primary substrate (1; 11) not covered with the masking layer (2); and
a fourth step for forming the electroconductive layer by electroless plating on the roughened portion, **characterized in that** the masking layer (2) is formed of cycloolefin resin not mixed with flexible polymer, which has compatibility with the primary substrate (1; 11), to cover the surface of the primary substrate (1; 11) other than a portion thereof on which an electroconductive layer of a predetermined circuit pattern is to be formed,
wherein a step for providing polarity (wetting) is omitted in the fourth step.

2. A method for forming an electroconductive circuit, comprising:
a first step for forming a primary substrate (1; 11) by injection molding cycloolefin resin not mixed with flexible polymer;
a second step for forming a secondary substrate (3; 13) by injection molding a masking layer (2);
a third step for roughening the surface of the masking layer (2) to be plated; and
a fourth step for forming the electroconductive layer by electroless plating on the roughened portion, **characterized in that** the masking layer (2) is formed of cycloolefin resin mixed with flexible polymer, which has compatibility with the primary substrate (1; 11), on a portion of the surface of the primary substrate (1; 11) on which an electroconductive layer of a predetermined circuit pattern is to be formed,
wherein a step for providing polarity (wetting) is omitted in the fourth step.

3. The method for forming an electroconductive circuit according to claim 2,
wherein the primary substrate (1; 11) has a through-hole, and a portion of the masking layer (2) to be plated is injection molded onto the both surfaces of the primary substrate (1; 11) via the through-hole.

4. The method for forming an electroconductive circuit according to any one of claims 1 to 3, which further comprises:
a fifth step for forming an electrolysis plating on the electroconductive layer after the fourth step for forming the electroconductive layer, and
a sixth step for removing non-electroconductive deposit residues left on the surface of the cycloolefin resin not mixed with flexible polymer by chemical dissolution.

5. The method for forming an electroconductive circuit according to any one of claims 1 to 4, wherein the cycloolefin resin is cycloolefin copolymer resin comprising cycloolefin resin and linear olefin.

## Patentansprüche

1. Verfahren zum Bilden einer elektrisch leitenden Schaltung, das umfasst:
einen ersten Schritt, um ein primäres Substrat (1; 11) durch Spritzgießen eines Cycloolefin-Harzes, das mit flexiblem Polymer gemischt ist, zu bilden;
einen zweiten Schritt, um ein sekundäres Substrat (3; 13) durch Spritzgießen einer Maskierungsschicht (2) zu bilden;
einen dritten Schritt, um den Abschnitt der Oberfläche des primären Substrats (1; 11), der nicht mit der Maskierungsschicht (2) bedeckt ist, aufzurauen; und
einen vierten Schritt, um die elektrisch leitende Schicht durch stromloses Überziehen des aufgerauten Abschnitts zu bilden, **dadurch gekennzeichnet, dass** die Maskierungsschicht (2) aus Cycloolefin-Harz, das nicht mit flexiblem Polymer gemischt ist, gebildet wird, wobei das Cycloolefin-Harz mit dem primären Substrat (1; 11) kompatibel ist, um die Oberfläche des primären Substrats (1; 11) mit Ausnahme eines Abschnitts, auf dem eine elektrisch leitende Schicht eines vorgegebenen Schaltungsmusters gebildet werden soll, zu bedecken,
wobei ein Schritt des Schaffens einer Polarität (Benetzens) im vierten Schritt weggelassen wird.

2. Verfahren zum Bilden einer elektrisch leitenden Schaltung, das umfasst:
einen ersten Schritt, um ein primäres Substrat (1; 11) durch Spritzgießen von Cycloolefin-Harz, das nicht mit flexiblem Polymer gemischt ist, zu bilden;
einen zweiten Schritt, um ein sekundäres Substrat (3; 13) durch Spritzgießen einer Maskierungsschicht (2) zu bilden;
einen dritten Schritt, um die zu überziehende Oberfläche der Maskierungsschicht (2) aufzurauen; und
einen vierten Schritt, um die elektrisch leitende Schicht durch stromloses Überziehen des aufgerauten Abschnitts zu bilden, **dadurch gekennzeichnet, dass** die Maskierungsschicht (2) aus Cycloolefin-Harz, das mit flexiblem Polymer gemischt ist und mit dem primären Substrat (1; 11) kompatibel ist, auf einem Abschnitt der Oberfläche des primären Substrats (1; 11), auf dem eine elektrisch leitende Schicht eines vorgegebenen Schaltungsmusters gebildet werden soll, gebildet wird,
wobei ein Schritt des Schaffens einer Polarität (Benetzen) im vierten Schritt weggelassen wird.

3. Verfahren zum Bilden einer elektrisch leitenden Schaltung nach Anspruch 2, wobei das primäre Substrat (1; 11) ein Durchgangsloch besitzt und ein Abschnitt der Maskierungsschicht (2), der überzogen werden soll, durch Spritzgießen auf beiden Oberflächen des primären Substrats (1; 11) durch das Durchgangsloch gebildet wird.

4. Verfahren zum Bilden einer elektrisch leitenden Schaltung nach einem der Ansprüche 1 bis 3, das ferner umfasst:
einen fünften Schritt, um ein Überziehen mittels Elektrolyse der elektrisch leitenden Schicht nach dem vierten Schritt zu bilden, um die elektrisch leitende Schicht zu bilden, und
einen sechsten Schritt, um die Reste einer nicht elektrisch leitenden Ablagerung, die auf der Oberfläche des nicht mit flexiblem Polymer gemischten Cycloolefin-Harzes zurückbleiben, mittels chemischer Auflösung zu entfernen.

5. Verfahren zum Bilden einer elektrisch leitenden Schaltung nach einem der Ansprüche 1 bis 4, wobei das Cycloolefin-Harz Cycloolefin-Copolymerharz ist, das Cycloolefin-Harz und lineares Olefin enthält.

## Revendications

1. Procédé pour former un circuit électroconducteur, comprenant :
une première étape consistant à former un substrat primaire (1 ; 11) par moulage-injection d'une résine cyclooléfine mélangée avec un polymère flexible ;
une seconde étape consistant à former un substrat secondaire (3 ; 13) par moulage-injection d'une couche de masquage (2) ;
une troisième étape consistant à rendre rugueuse la portion de la surface du substrat primaire (1 ; 11) qui n'est pas couverte avec la couche de masquage (2) ; et
une quatrième étape consistant à former la couche électroconductrice par placage sans électrolyse sur la portion rugueuse,
**caractérisé en ce que** la couche de masquage (2) est formée d'une résine cyclooléfine qui n'est pas mélangée avec du polymère flexible, qui présente une compatibilité avec le substrat primaire (1 ; 11), pour couvrir la surface du substrat primaire (1 ; 11) autre qu'une portion de celui-ci et sur laquelle il s'agit de former une couche électroconductrice avec un motif de circuit prédéterminé,
dans lequel une étape consistant à assurer une polarité (mouillage) est omise dans la quatrième étape.

2. Procédé pour former un circuit électroconducteur, comprenant :
une étape consistant à former un substrat primaire (1 ; 11) par moulage-injection d'une résine cyclooléfine qui n'est pas mélangée avec un polymère flexible ;
une seconde étape consistant à former un substrat secondaire (3 ; 13) par moulage-injection d'une couche de masquage (2) ;
une troisième étape consistant à rendre rugueuse la surface de la couche de masquage (2) qu'il s'agit de plaquer ; et
une quatrième étape consistant à former la couche électroconductrice par placage sans électrolyse sur la portion rugueuse,
**caractérisé en ce que** la couche de masquage (2) est formée de résine cyclooléfine mélangée avec un polymère flexible, qui présente une compatibilité avec le substrat primaire (1 ; 11), sur une portion de la surface du substrat primaire (1 ; 11) sur laquelle il s'agit de former une couche électroconductrice d'un motif de circuit prédéterminé,
dans lequel une étape consistant à assurer une polarité (mouillage) est omise dans la quatrième étape.

3. Procédé pour former un circuit électroconducteur selon la revendication 2,
dans lequel le substrat primaire (1 ; 11) comporte un trou traversant, et une portion de la couche de masquage (2) qu'il s'agit de plaquer est moulée par injection sur les deux surfaces du substrat primaire (1 ; 11) via le trou traversant.

4. Procédé pour former un circuit électroconducteur selon l'une quelconque des revendications 1 à 3, qui comprend en en outre :
une cinquième étape consistant à former un placage par électrolyse sur la couche électroconductrice après la quatrième étape consistant à former la couche électroconductrice, et
une sixième étape consistant à enlever des résidus de dépôt non-électroconducteur laissés sur la surface de la résine cyclooléfine qui n'est pas mélangée avec un polymère flexible, par dissolution chimique.

5. Procédé pour former un circuit électroconducteur selon l'une quelconque des revendications 1 à 4, dans lequel la résine cyclooléfine est une résine copolymère cyclooléfine comprenant une résine cyclooléfine et une oléfine linéaire.
